(19) Europäisches Patentamt
European Patent Office
Office européen des brevets

(11) **EP 3 656 805 A1**

# EUROPEAN PATENT APPLICATION
published in accordance with Art. 153(4) EPC

(43) Date of publication:
**27.05.2020 Bulletin 2020/22**

(21) Application number: **19803845.7**

(22) Date of filing: **16.01.2019**

(51) Int Cl.:
*C08J 5/18* (2006.01)      *H01L 51/00* (2006.01)
*H01L 51/56* (2006.01)     *C08G 73/10* (2006.01)
*C08L 79/08* (2006.01)

(86) International application number:
**PCT/KR2019/000639**

(87) International publication number:
**WO 2019/221364 (21.11.2019 Gazette 2019/47)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **14.05.2018 KR 20180054983**
**18.12.2018 KR 20180164186**

(71) Applicant: **LG CHEM, LTD.**
**Yeongdeungpo-gu,**
**Seoul 07336 (KR)**

(72) Inventors:
• **PARK, Jinyoung**
**Daejeon 34122 (KR)**
• **KIM, Kyunghwan**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **POLYIMIDE FILM FOR FLEXIBLE DISPLAY DEVICE SUBSTRATE HAVING EXCELLENT HEAT DISSIPATION CHARACTERISTICS**

(57)    The present invention can provide a substrate for a flexible display device, the substrate having a positive CTE value without deterioration in heat resistance even at a temperature of 350 °C or higher, by providing a polyimide obtained from the polymerization of polymerization elements in which p-PDA as a diamine is added in excess of s-BPDA as an acid dianhydride and a terminal sealant containing phthalic anhydride (PA) is added. In addition, such a manufacturing method allows the production of a polyimide film, which has higher transmittance than a polyimide film manufactured with a composition simply having an excess of a diamine, so that TFT devices can be fabricated through alignment keys more easily when the devices are fabricated on polyimide substrates.

[Fig. 1]

**Description**

BACKGROUND OF THE INVENTION

1. Field of the Invention

This application claims the benefit of priorities to Korean Patent Application Nos. 10-2018-0054983, filed on May 14, 2018 and 10-2018-0164186, filed on December 18, 2018, the entire disclosures of which are incorporated herein by reference.

The present invention relates to a polyimide film for a flexible display device substrate having improved heat dissipation properties and a method of manufacturing the same.

2. Description of the Related Art

Polyimide (PI) is a polymer having a relatively low crystallinity or mostly non-crystalline structure, which has an advantage that it is easy to synthesize, can be formed to a thin film and does not require a crosslinking group for curing. Also, polyimide is a polymeric material that has excellent heat resistance and chemical resistance, and good mechanical properties, electrical properties and dimensional stability due to its rigid chain structure in addition to its transparency. Therefore, it is widely used as electrical and electronic materials for automobiles, aerospace, flexible circuit boards, liquid crystal alignment films for LCDs, and adhesives and coatings.

In particular, polyimide is a high-performance polymer material having high thermal stability, mechanical properties, chemical resistance, and electrical properties and it is increasingly attracting attention as a substrate material for a flexible display device. However, it has to be transparent for use in display applications, and the thermal expansion coefficient must not be negative at a temperature of 350 °C or more in order to lower defects due to the residual stress of the substrate in a heat treatment process for producing display devices. Therefore, there are many studies to minimize the change of optical characteristics and thermal history while maintaining the basic characteristics of polyimide. In order to realize such a flexible display, polyimide composed of BPDA (3,3',4,4'-biphenyltetracarboxylic dianhydride)-PDA (phenylene diamine) having excellent heat resistance is mainly used.

A flexible display device is increasingly in demand in the market due to its free form factor, lightweight and thin features and unbreakable characteristics. The flexible display device, for example a TFT device, is fabricated by depositing a multilayer inorganic film such as a buffer layer, an active layer, and a gate insulator on a cured polyimide substrate.

Recently, there is an issue that a polyimide substrate used in the implementation of an OLED-type flexible display is vulnerable to image sticking, compared to a glass substrate. The cause of the image sticking is presumed to be the current fluctuation due to the shift of threshold voltage ($V_{th}$) in a current driven type OLED display. The inventors of the present invention have studied to solve the image sticking problem and found that the shift of $V_{th}$ becomes greater due to the heat generated when the TFT is driven.

Since a plastic substrate such as a polyimide substrate has lower thermal diffusivity and thermal conductivity than a glass substrate, the heat generated in driving LTPS TFT cannot be dissipated more easily than the glass substrate. Therefore, when the OLED is used for a long time, there is increase in the electric stress of the substrate material due to the electromagnetic field according to the long driving time of the TFT device and in the temperature of the electric stress-sensitive TFT device. As a result, a current fluctuation occurs at a constant gate voltage in a TFT device having an increased temperature, resulting in degradation of image sticking characteristics.

Accordingly, by improving the heat dissipation characteristics of the plastic substrate material, it is possible to improve the dissipation of heat generated in the TFT device and to minimize the change in the shift of $V_{th}$ due to heat generated in the device.

SUMMARY OF THE INVENTION

The present invention provides a polyimide film which can improve heat dissipation characteristics, that is, thermal conductivity and thermal diffusivity, thereby alleviating the $V_{th}$ shift.

Further, the present invention provides a method for producing the polyimide film.

Further, the present invention provides a flexible display device comprising the polyimide film.

The present invention provides a polyimide film which is produced from a polymerization composition comprising 3,3',4,4'-biphenylcarboxylic dianhydride (s-BPDA), 4,4'-paraphenylenediamine (p-PDA), 2,2'-bis(trifluoromethyl)benzidine (TFMB) and phthalic anhydride, the polyimide in the film being end-capped with phthalic anhydride and the polyimide film having a crystallinity of at least 0.5.

According to one embodiment, the thermal diffusivity of the film may be 0.07 mm$^2$/s or more.

According to one embodiment, the thermal conductivity of the film may be 0.15 W/m·K or more.

According to one embodiment, the molar ratio of 4,4'-paraphenylenediamine (p-PDA) to 2,2'-bis(trifluoromethyl)benzidine (TFMB) may be 90:10 to 95:5.

According to one embodiment, the molar ratio of the total of 4,4'-paraphenylenediamine (p-PDA) and 2,2'-bis(trifluoromethyl)benzidine (TFMB) to 3,3',4,4'-biphenylcarboxylic dianhydride (s-BPDA) may be 100:98.9 to 100:98.75.

According to one embodiment, the phthalic anhydride may be reacted in a molar ratio of 0.02 to 0.025 relative to 1 mole of the total of 4,4'-paraphenylenediamine (p-PDA) and 2,2'-bis(trifluoromethyl)benzidine (TFMB).

Further, the present invention provides a method for producing a polyimide film, comprising the steps of:

adding a polymerization component comprising 4,4'-paraphenylenediamine (p-PDA), 2,2'-bis(trifluoromethyl)benzidine (TFMB) and 3,3',4,4'-biphenylcarboxylic dianhydride (s-BPDA) and phthalic anhydride (PA) as an end-capper to a polymerization solvent to prepare a polyimide precursor;
preparing a polyimide precursor solution comprising the polyimide precursor and an organic solvent;
applying the polyimide precursor solution on a substrate; and
drying and heating the applied polyimide precursor solution.

According to one embodiment, the final curing temperature in the curing process by a drying and heating of the polyimide precursor solution may be 450 °C or more.

In order to solve another problem of the present invention, there is provided a flexible display device comprising the polyimide film.

EFFECT OF THE INVENTION

The present invention relates to a flexible display device having improved heat dissipation characteristics by providing a polyimide film which is produced from a polyimide obtained by end-capping with phthalic anhydride (PA) with using p-PDA and TFMB as a diamine and s-BPDA as an acid anhydride, and having a crystallinity of 0.5 or more. Further, the film according to the present invention can minimize the change of the $V_{th}$ shift caused by heat generated in the device by manufacturing a polyimide film having a crystallinity higher than that of a polyimide film produced from a composition just with an excess of diamine.

BRIEF DESCRIPTION OF THE DRAWINGS

Fig. 1 schematically shows the relationship between crystallinity and heat dissipation characteristics of a film.
Figs. 2 and 3 are graphs comparing crystallinity of the films according to Examples and Comparative Examples.

DETAILED DESCRIPTION OF THE INVENTION

Since various modifications and variations can be made in the present invention, particular embodiments are illustrated in the drawings and will be described in detail in the detailed description. It should be understood, however, that the invention is not intended to be limited to the particular embodiments, but includes all modifications, equivalents, and alternatives falling within the spirit and scope of the invention. In the following description of the present invention, detailed description of known functions will be omitted if it is determined that it may obscure the gist of the present invention.

There is provided a polyimide film which is produced from a polyimide comprising 3,3',4,4'-biphenylcarboxylic dianhydride (s-BPDA), 4,4'-paraphenylenediamine (p-PDA) and 2,2'-bis(trifluoromethyl)benzidine (TFMB) as a polymerization component and end-capped with phthalic anhydride and which has a crystallinity of 0.5 or more.

In general, efforts have been made to improve the physical properties of a polyimide film by focusing on stability of viscosity and molecular weight of the polyimide precursor solution by reacting the diamine excessively in the process of preparing the polyimide. However, there may arise a problem of thermal stability such as a negative thermal expansion coefficient of the polyimide film produced from a composition just with an excess of diamine at a high temperature.

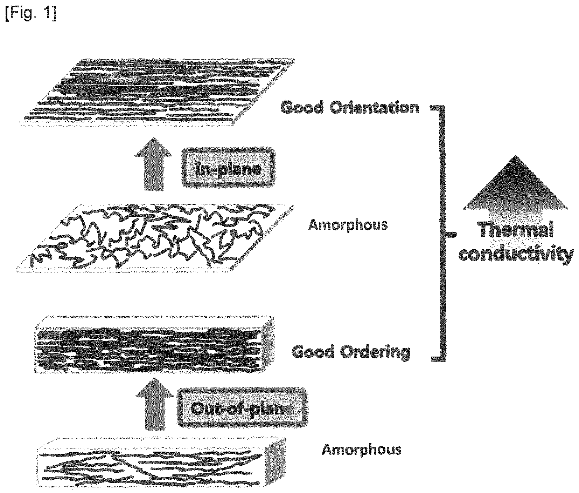

The present inventors have studied to improve orientation or ordering of a polyimide polymer chain used as a plastic OLED substrate material and have found that orientation in-plane direction of the polymer chain can be improved with a polyimide having BPDA-PDA-TFMB copolymer as a main component and polymer chain ordering in the out-of-plane direction can be improved by using phthalic anhydride as an end-capper (see Fig. 1). This improvement in crystallinity ultimately causes a rise in thermal diffusivity and thermal conductivity of the polyimide used as a substrate material.

Accordingly, in order to provide a polyimide having improved mechanical properties while improving heat dissipation characteristics, in the present invention, the main chain of BPDA-pPDA-TFMB was end-capped with phthalic anhydride (PA) to improve a crystallinity to 0.5 or more.

Herein, the term 'crystallinity (Xcr)' is also referred to as 'degree of crystallinity', and can be determined by the following equation (1) using GI-XRD (Grazing incidence X-ray Diffraction):

[Equation 1]

$$\chi_{cr} = \frac{I_c}{I_c + I_a}$$

wherein, Ic is an area under crystalline peak, and Ia is an area under non-crystalline peak.

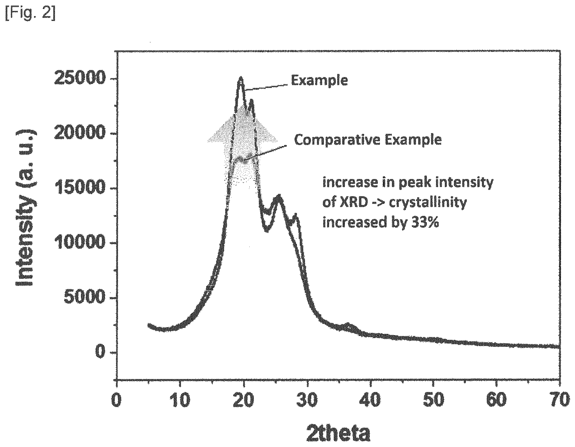

For example, TOPAS version 4.2 program was used to determine crystalline and non-crystalline peaks in the XRD graph as in Fig. 2. Using the TOPAS program, crystalline peaks ($2\theta \fallingdotseq 18.4°$, $21.3°$, $25.5°$ and $28.1°$) is taken in the range of $8° < 2\theta < 35°$, and the crystallinity can be calculated from these areas.

The film according to the present invention may have a thermal diffusivity of 0.07 $mm^2$/s or more, or 0.08 $mm^2$/s or more, or 0.09 $mm^2$/s or more. The thermal diffusivity can be measured using LFA 467 Hyperflash at room temperature. The higher the thermal diffusivity, the better the heat dissipation characteristic.

The film according to the present invention may have a thermal conductivity of 0.2 W/mK or more. The thermal conductivity can be calculated by the following equation (2). The higher the thermal conductivity, the better the heat dissipation characteristic.

[Equation 2]

Thermal conductivity (k) = C × ρ × α

wherein, C represents the specific heat (J/g·K), p represents density (g/$cm^3$) and $\alpha$ represents thermal diffusivity ($mm^2$/sec).

According to one embodiment, the molar ratio of 4,4'-paraphenylenediamine (pPDA) to 2,2'-bis(trifluoromethyl)benzidine (TFMB) may be about 95: 5 to 90: 10, preferably about 95: 5 and more preferably about 90: 10.

In addition, the molar ratio of the total of 4,4'-paraphenylenediamine (p-PDA) and 2,2'-bis(trifluoromethyl)benzidine (TFMB) to 3,3',4,4'-biphenylcarboxylic dianhydride (s-BPDA) may be about 100: 98.9 to 100: 98.75, preferably about 100: 98.9, and more preferably about 100: 98.75.

According to one embodiment, the phthalic anhydride may be reacted in a molar ratio of 0.02 to 0.025, preferably 0.022 to 0.025 relative to 1 mole of the total of 4,4'-paraphenylenediamine (pPDA) and 2,2'-bis(trifluoromethyl)benzidine (TFMB).

The crystallinity and heat dissipation characteristics of the polyimide can be maximized within the above-mentioned range of molar ratio.

Further, the present invention provides a method for producing a polyimide film, comprising the steps of:

adding a polymerization component comprising 4,4'-paraphenylenediamine (p-PDA), 2,2'-bis(trifluoromethyl)benzidine (TFMB) and 3,3',4,4'-biphenylcarboxylic dianhydride (s-BPDA) and phthalic anhydride (PA) as an end-capper to a polymerization solvent to prepare a polyimide precursor;
preparing a polyimide precursor solution comprising the polyimide precursor and an organic solvent;
applying the polyimide precursor solution on a substrate; and
drying and heating the applied polyimide precursor solution.

According to one embodiment, the final curing temperature in the curing process by a drying and heating of the polyimide precursor solution may be 450 °C or more.

In order to solve another problem of the present invention, there is provided a flexible display device comprising the polyimide film.

According to one embodiment, 3,3',4,4'-biphenylcarboxylic dianhydride (s-BPDA) to the total of 4,4'-paraphenylenediamine (pPDA) and 2,2'-bis(trifluoromethyl)benzidine (TFMB) can be used in a molar ratio of 0.98: 1 to 0.99: 1, preferably 0.9875: 1 to 0.9890: 1.

Further, by adding phthalic anhydride, the heat resistance and the permeability can be improved. The phthalic anhydride is added in a molar ratio of 0.02 to 0.025 mol, preferably 0.022 to 0.025 mol based on 1 mole of pPDA.

Examples of the method for end-capping the terminal of the polyimide obtained from the diamine and the tetracarboxylic dianhydride using an end-capper include a method of reacting a tetracarboxylic dianhydride and a diamine, followed by adding an end-capper, a method of reacting an end-capper and a diamine, followed by adding a tetracarboxylic dianhydride, and a method in which a tetracarboxylic dianhydride, a diamine and an end-capper are simultaneously reacted. The polyimide precursor with end-capped can be polymerized by the above reaction.

The polymerization of the above mentioned polyimide precursor may be carried out by a typical process for polymerization of polyimide precursors such as solution polymerization, etc.

The polymerization reaction may be carried out under anhydrous conditions. The reaction temperature during the polymerization reaction may be -75 to 50 °C, preferably 0 to 40 °C. Diamine is dissolved in an organic solvent and then is subjected to a polymerization reaction by adding acid dianhydride. The diamine and the acid dianhydride may be contained in an amount of about 10 to 30% by weight in the polymerization solvent, and the molecular weight can be adjusted according to a polymerization time and a reaction temperature.

In addition, the organic solvent that can be used in the polymerization reaction may be selected from the group consisting of ketones such as gamma-butyrolactone, 1,3-dimethyl-imidazolidinone, methyl ethyl ketone, cyclohexanone, cyclopentanone and 4-hydroxy-4-methyl-2-pentanone; aromatic hydrocarbons such as toluene, xylene and tetramethylbenzene; glycol ethers (Cellosolve) such as ethylene glycol monoethyl ether, ethylene glycol monomethyl ether, ethylene glycol monobutyl ether, diethylene glycol monoethyl ether, diethylene glycol monomethyl ether, diethylene glycol monobutyl ether, propylene glycol monomethyl ether, propylene glycol monoethyl ether, dipropylene glycol diethyl ether and triethylene glycol monoethyl ether; ethyl acetate, butyl acetate, ethylene glycol monoethyl ether acetate, ethylene glycol monobutyl ether acetate, diethylene glycol monoethyl ether acetate, dipropylene glycol monomethyl ether acetate, ethanol, propanol, ethylene glycol, propylene glycol, carbitol, dimethylacetamide (DMAc), N,N-diethylacetamide, dimethylformamide (DMF), diethylformamide (DEF), N-methylpyrrolidone (NMP), N-ethylpyrrolidone (NEP), N-vinylpyrolidone, 1,3-dimethyl-2-imidazollidine, N,N-dimethylmethoxyacetamide, dimethylsulfoxide, pyridine, dimethylsulfone, hexamethylphosphoramide, tetramethylurea, N-methylcaprolactam, tetrahydrofuran, m-dioxane, p-dioxane, 1,2-dimethoxyethane, bis(2-methoxyethyl)ether, 1,2-bis(2-methoxyethoxy)ethane, bis[2-(2-methoxyethoxy)]ether, and a mixture thereof.

Preferably, sulfoxide-based solvents such as dimethyl sulfoxide and diethyl sulfoxide; formamide-based solvents such as N,N-dimethylformamide and N,N-diethylformamide; acetamide-based solvents such as N,N-dimethylacetamide and N,N-diethylacetamide; pyrrolidone solvents such as N-methyl-2-pyrrolidone and N-vinyl-2-pyrrolidone may be used alone or as a mixture, but the present invention is not limited thereto. Further, aromatic hydrocarbons such as xylene and toluene can be further used.

The method for producing a polyimide film using the polyimide precursor comprised the steps of applying the polyimide precursor composition comprising the polyimide precursor and the organic solvent on one surface of a substrate, imidizing and curing it, and then separating it from the substrate.

Specifically, the polyimide precursor composition may be in the form of a solution in which the polyimide precursor is dissolved in an organic solvent. For example, when the polyimide precursor is synthesized in an organic solvent, the solution may be the reaction solution as obtained, or may be obtained by diluting this reaction solution with another solvent. When the polyimide precursor is obtained as a solid powder, it may be dissolved in an organic solvent to prepare a solution.

It is preferred that the polyimide precursor composition contains a solid content in an amount such that the composition has an appropriate viscosity in consideration of processibility such as coating properties during a film-forming step. The solid content may be 5 to 20 wt% based on the total weight of the polyimide precursor composition. Alternatively, the polyimide precursor composition may be preferably adjusted to have a viscosity of 400 cP to 50,000 cP. The viscosity of the polyimide precursor composition may be less than 400 cP. When the viscosity of the polyimide precursor composition exceeds 50,000 cP, the flowability during the production of the display substrate using the polyimide precursor composition may be lowered, which may cause problems in the manufacturing process such as not being uniformly applied during coating.

Next, the polyimide film can be produced by applying the polyimide precursor composition to one surface of the substrate, thermally imidizing and curing it at a temperature of 80 °C to 500 °C, and then separating it from the substrate.

As the substrate, a glass substrate, a metal substrate, a plastic substrate, or the like can be used without any particular limitation. Among them, a glass substrate may be preferable which is excellent in thermal and chemical stability during the imidization and curing process for the polyimide precursor and can be easily separated even without any treatment with additional release agent while not damaging the polyimide film obtained after curing.

The applying process may be carried out according to a conventional application method. Specifically, a spin coating method, a bar coating method, a roll coating method, an air knife method, a gravure method, a reverse roll method, a kiss roll method, a doctor blade method, a spray method, a dipping method, a brushing method, or the like may be used. Of these, it is more preferable to carry out by a casting method which allow a continuous process and enables to increase an imidization rate of polyimide.

In addition, the polyimide precursor composition may be applied on the substrate to the thickness range such that the polyimide film to be finally produced has a thickness suitable for a display substrate.

Specifically, it may be applied in an amount such that the thickness is 10 to 30 μm. After the application of the polyimide precursor composition, a drying process for removing the solvent present in the polyimide precursor composition may be further optionally performed, prior to the curing process.

The drying process may be carried out according to a conventional method, specifically at a temperature of 140 °C or lower, or 80 °C to 140 °C. If the drying temperature is lower than 80 °C, the drying process becomes longer. If the drying temperature is higher than 140 °C, the imidization rapidly proceeds to make it difficult to form a polyimide film having a uniform thickness.

Then, the curing process may be carried out by heat treatment at a temperature of 80 °C to 500 °C. The curing process may be carried out by a multi-stage heat treatment at various temperatures within the above-mentioned temperature range. The curing time in the curing step is not particularly limited and may be, for example, 30 to 60 minutes.

Further, a subsequent heat treatment process may be further optionally performed to increase the imidization ratio of the polyimide in the polyimide film after the curing process, thereby forming the polyimide-based film having the above-mentioned physical properties.

The subsequent heat treatment process is preferably performed at 200 °C or higher, or 200 °C to 500 °C for 1 minute to 30 minutes. The subsequent heat treatment process may be performed in a single stage or in a multi stage such as two or more stages. Specifically, it may be carried out in three stages including a first heat treatment at 200 to 220 °C, a second heat treatment at 300 to 380 °C, and a third heat treatment at 400 to 500 °C. It is preferable to cure in a condition that the final curing temperature is 450 °C or higher for 30 minutes or more and 2 hour or less, preferably for 30 minutes or more and 1 hour or less.

Thereafter, the polyimide film may be manufactured by peeling the polyimide film formed on the substrate from the substrate by a conventional method.

The polyimide according to the present invention may have a glass transition temperature of about 360 °C or higher. Since the polyimide has such excellent heat resistance, the film containing the polyimide can maintain excellent heat resistance and mechanical properties against high-temperature heat added during the device manufacturing process.

The polyimide film according to the present invention may have a thermal decomposition temperature (Td 1%), which indicates a mass reduction of 1%, of 550 °C or higher.

The polyimide film according to the present invention has excellent mechanical properties. For example, an elongation may be 20% or more, preferably 25% or more, and a tensile strength may be 500 MPa or more, preferably 520 MPa or more, more preferably 530 MPa or more, and a tensile modulus may be 10 GPa or more.

The present invention provides a polyimide film end-capped with an end-capper containing phthalic anhydride, thereby exhibiting a positive CTE value even at a high temperature and solving problems caused by negative CTE (generation of shrinkage). In addition, it is possible to provide a polyimide film having high transmittance characteristics, preferably a polyimide film having a transmittance of 70% or more. When a device is fabricated on the above-described polyimide substrate, the TFT device can be easily manufactured through an align key.

The polyimide according to the present invention can be used as a substrate for a device, a cover substrate for a display device, an optical film, an IC (integrated circuit) package, an adhesive film, a multilayer flexible printed circuit (FPC), a tape, a touch panel, a protective film for optical discs, and the like.

The present invention provides a flexible display device comprising the polyimide film. For example, the display device includes a liquid crystal display device (LCD), an organic light emitting diode (OLED), or the like, particularly it is suitable for an OLED device using a low temperature polycrystalline silicon (LTPS) which requires a high temperature process, but is not limited thereto.

Hereinafter, embodiments of the present invention will be described in detail so that those skilled in the art can easily carry out the present invention. The present invention may, however, be embodied in many different forms and should not be construed as limited to the embodiments set forth herein.

<Example 1> Polymerization of polyimide, BPDA-pPDA-TFMB/ PA(98.9:95:5:2.2)

100 g of an organic solvent, NMP (N-methyl-2-pyrrolidone) was charged into a reactor equipped with a stirrer in a nitrogen stream, and then 5.731 g (52.999 mmol) of paraphenylene diamine (p-PDA) and 0.893 g (2.789 mmol) of 2,2'-bis(trifluoromethyl)benzidine (TFMB) were dissolved while maintaining the reactor temperature at 25 °C. To the solution of p-PDA and TFMB, 16.234 g (55.175 mmol) of 3,3',4,4'-biphenylcarboxylic dianhydride (s-BPDA) and 56.96 g of NMP were added at the same temperature and dissolved with stirring for a predetermined time to obtain a polyamic acid. Then, 0.182 g (1.227 mmol) of phthalic anhydride (PA) was added to the polyamic acid solution and stirred for a predetermined time to prepare a polyimide precursor.

The organic solvent was added in such as amount that the solid concentration of the polyimide precursor solution prepared from the reaction is 12.8 wt% to prepare a polyimide precursor solution.

The polyimide precursor solution was spin-coated on a glass substrate. The glass substrate coated with the polyimide precursor solution was placed in an oven, heated at a rate of 6 °C/min, and cured at 120 °C for 10 minutes and at 460 °C for 55 minutes. After completion of the curing process, the glass substrate was immersed in water and the film formed on the glass substrate was peeled off and dried at 100 °C in the oven to prepare a polyimide film having a thickness of 10 μm.

<Example 2> Polymerization of polyimide, BPDA-pPDA-TFMB/ PA(98.75:95:5:2.5)

100 g of an organic solvent, NMP (N-methyl-2-pyrrolidone) was charged into a reactor equipped with a stirrer in a nitrogen stream, and then 5.731 g (52.999 mmol) of paraphenylene diamine (p-PDA) and 0.893 g (2.789 mmol) of 2,2'-bis(trifluoromethyl)benzidine (TFMB) were dissolved while maintaining the reactor temperature at 25 °C. To the solution of p-PDA and TFMB, 16.209 g (55.091 mmol) of 3,3',4,4'-biphenylcarboxylic dianhydride (s-BPDA) and 56.96 g of NMP were added at the same temperature and dissolved with stirring for a predetermined time to obtain a polyamic acid. Then, 0.207 g (1.395 mmol) of phthalic anhydride (PA) was added to the polyamic acid solution and stirred for a predetermined time to prepare a polyimide precursor.
The organic solvent was added in such as amount that the solid concentration of the polyimide precursor solution prepared from the reaction is 12.8 wt% to prepare a polyimide precursor solution.
A polyimide film having a thickness of 10 μm was prepared in the same manner as in Example 1.

<Example 3> Polymerization of polyimide, BPDA-pPDA-TFMB/ PA(98.9:90:10:2.2)

100 g of an organic solvent, NMP (N-methyl-2-pyrrolidone) was charged into a reactor equipped with a stirrer in a nitrogen stream, and then 5.294 g (48.953 mmol) of paraphenylene diamine (p-PDA) and 1.742 g (5.439 mmol) of 2,2'-bis(trifluoromethyl)benzidine (TFMB) were dissolved while maintaining the reactor temperature at 25 °C. To the solution of p-PDA and TFMB, 15.827 g (53.794 mmol) of 3,3',4,4'-biphenylcarboxylic dianhydride (s-BPDA) and 56.96 g of NMP were added at the same temperature and dissolved with stirring for a predetermined time to obtain a polyamic acid. Then, 0.177 g (1.197 mmol) of phthalic anhydride (PA) was added to the polyamic acid solution and stirred for a predetermined time to prepare a polyimide precursor.
The organic solvent was added in such as amount that the solid concentration of the polyimide precursor solution prepared from the reaction is 12.8 wt% to prepare a polyimide precursor solution.
A polyimide film having a thickness of 10 μm was prepared in the same manner as in Example 1.

<Example 4> Polymerization of polyimide, BPDA-pPDA-TFMB/ PA(98.75:90:10:2.5)

100 g of an organic solvent, NMP (N-methyl-2-pyrrolidone) was charged into a reactor equipped with a stirrer in a nitrogen stream, and then 5.294 g (48.953 mmol) of paraphenylene diamine (p-PDA) and 1.742 g (5.439 mmol) of 2,2'-bis(trifluoromethyl)benzidine (TFMB) were dissolved while maintaining the reactor temperature at 25 °C. To the solution of p-PDA and TFMB, 15.803 g (53.712 mmol) of 3,3',4,4'-biphenylcarboxylic dianhydride (s-BPDA) and 56.96 g of NMP were added at the same temperature and dissolved with stirring for a predetermined time to obtain a polyamic acid. Then, 0.201 g (1.360 mmol) of phthalic anhydride (PA) was added to the polyamic acid solution and stirred for a predetermined time to prepare a polyimide precursor.
The organic solvent was added in such as amount that the solid concentration of the polyimide precursor solution prepared from the reaction is 12.8 wt% to prepare a polyimide precursor solution.
A polyimide film having a thickness of 10 μm was prepared in the same manner as in Example 1.

<Comparative Example 1> Polymerization of polyimide, BPDA-pPDA(98.9:100)

100 g of an organic solvent, NMP (N-methyl-2-pyrrolidone) was charged into a reactor equipped with a stirrer in a nitrogen stream, and then 6.243 g (57.726 mmol) of paraphenylene diamine (p-PDA) was dissolved while maintaining the reactor temperature at 25 °C. To the solution of p-PDA, 16.797 g (57.091 mmol) of 3,3',4,4'-biphenylcarboxylic dianhydride (s-BPDA) and 56.96 g of NMP were added at the same temperature and dissolved with stirring for a predetermined time to prepare a polyimide precursor.
The organic solvent was added in such as amount that the solid concentration of the polyimide precursor solution prepared from the reaction is 12.8 wt% to prepare a polyimide precursor solution.
A polyimide film having a thickness of 10 μm was prepared in the same manner as in Example 1.

<Comparative Example 2> Polymerization of polyimide, BPDA-pPDA(98.75:100)

100 g of an organic solvent, NMP (N-methyl-2-pyrrolidone) was charged into a reactor equipped with a stirrer in a nitrogen stream, and then 6.249 g (57.790 mmol) of paraphenylene diamine (p-PDA) was dissolved while maintaining the reactor temperature at 25 °C. To the solution of p-PDA, 16.791 g (57.068 mmol) of 3,3',4,4'-biphenylcarboxylic dianhydride (s-BPDA) and 56.96 g of NMP were added at the same temperature and dissolved with stirring for a predetermined time to prepare a polyimide precursor.

The organic solvent was added in such as amount that the solid concentration of the polyimide precursor solution prepared from the reaction is 12.8 wt% to prepare a polyimide precursor solution.

A polyimide film having a thickness of 10 $\mu$m was prepared in the same manner as in Example 1.

<Comparative Example 3> Polymerization of polyimide, BPDA-pPDA-TFMB(98.9:95:5)

100 g of an organic solvent, NMP (N-methyl-2-pyrrolidone) was charged into a reactor equipped with a stirrer in a nitrogen stream, and then 5.777 g (53.421 mmol) of paraphenylene diamine (p-PDA) and 0.900 g (2.812 mmol) of 2,2'-bis(trifluoromethyl)benzidine (TFMB) were dissolved while maintaining the reactor temperature at 25 °C. To the solution of p-PDA and TFMB, 16.363 g (55.614 mmol) of 3,3',4,4'-biphenylcarboxylic dianhydride (s-BPDA) and 56.96 g of NMP were added at the same temperature and dissolved with stirring for a predetermined time to obtain a polyamic acid.

The organic solvent was added in such as amount that the solid concentration of the polyimide precursor solution prepared from the reaction is 12.8 wt% to prepare a polyimide precursor solution.

A polyimide film having a thickness of 10 $\mu$m was prepared in the same manner as in Example 1.

<Comparative Example 4> Polymerization of polyimide, BPDA-pPDA-TFMB(98.9:90:10)

100 g of an organic solvent, NMP (N-methyl-2-pyrrolidone) was charged into a reactor equipped with a stirrer in a nitrogen stream, and then 5.335 g (49.332 mmol) of paraphenylene diamine (p-PDA) and 1.755 g (5.481 mmol) of 2,2'-bis(trifluoromethyl)benzidine (TFMB) were dissolved while maintaining the reactor temperature at 25 °C. To the solution of p-PDA and TFMB, 15.950 g (54.211 mmol) of 3,3',4,4'-biphenylcarboxylic dianhydride (s-BPDA) and 56.96 g of NMP were added at the same temperature and dissolved with stirring for a predetermined time to obtain a polyamic acid.

The organic solvent was added in such as amount that the solid concentration of the polyimide precursor solution prepared from the reaction is 12.8 wt% to prepare a polyimide precursor solution.

A polyimide film having a thickness of 10 $\mu$m was prepared in the same manner as in Example 1.

<Comparative Example 5> Polymerization of polyimide, BPDA-pPDA-TFMB(98.75:95:5)

100 g of an organic solvent, NMP (N-methyl-2-pyrrolidone) was charged into a reactor equipped with a stirrer in a nitrogen stream, and then 5.783 g (53.478 mmol) of paraphenylene diamine (p-PDA) and 0.901 g (2.815 mmol) of 2,2'-bis(trifluoromethyl)benzidine (TFMB) were dissolved while maintaining the reactor temperature at 25 °C. To the solution of p-PDA and TFMB, 16.356 g (55.589 mmol) of 3,3',4,4'-biphenylcarboxylic dianhydride (s-BPDA) and 56.96 g of NMP were added at the same temperature and dissolved with stirring for a predetermined time to obtain a polyamic acid.

The organic solvent was added in such as amount that the solid concentration of the polyimide precursor solution prepared from the reaction is 12.8 wt% to prepare a polyimide precursor solution.

A polyimide film having a thickness of 10 $\mu$m was prepared in the same manner as in Example 1.

<Comparative Example 6> Polymerization of polyimide, BPDA-pPDA-TFMB(98.75:90:10)

100 g of an organic solvent, NMP (N-methyl-2-pyrrolidone) was charged into a reactor equipped with a stirrer in a nitrogen stream, and then 5.340 g (49.384 mmol) of paraphenylene diamine (p-PDA) and 1.757 g (5.487 mmol) of 2,2'-bis(trifluoromethyl)benzidine (TFMB) were dissolved while maintaining the reactor temperature at 25 °C. To the solution of p-PDA and TFMB, 15.942 g (54.185 mmol) of 3,3',4,4'-biphenylcarboxylic dianhydride (s-BPDA) and 56.96 g of NMP were added at the same temperature and dissolved with stirring for a predetermined time to obtain a polyamic acid.

The organic solvent was added in such as amount that the solid concentration of the polyimide precursor solution prepared from the reaction is 12.8 wt% to prepare a polyimide precursor solution.

A polyimide film having a thickness of 10 $\mu$m was prepared in the same manner as in Example 1.

<Comparative Example 7> Polymerization of polyimide, BPDA-pPDA-TFMB+KF-8010/PA(98.9:90:5:5:2.2)

100 g of an organic solvent, NMP (N-methyl-2-pyrrolidone) was charged into a reactor equipped with a stirrer in a nitrogen stream, and then 5.226 g (48.327 mmol) of paraphenylene diamine (p-PDA), 0.860 g (2.685 mmol) of 2,2'-bis(trifluoromethyl)benzidine (TFMB) and 1.154 g (2.685 mmol) of KF-8010 (manufactured by Shin-Etsu silicone) were dissolved while maintaining the reactor temperature at 25 °C. To the solution of p-PDA/TFMB/KF-8010, 15.625 g (53.106 mmol) of 3,3',4,4'-biphenylcarboxylic dianhydride (s-BPDA) and 56.96 g of NMP were added at the same temperature and dissolved with stirring for a predetermined time to obtain a polyamic acid.
The organic solvent was added in such as amount that the solid concentration of the polyimide precursor solution prepared from the reaction is 12.8 wt% to prepare a polyimide precursor solution.
A polyimide film having a thickness of 10 $\mu$m was prepared in the same manner as in Example 1.

<Comparative Example 8> Polymerization of polyimide, BPDA-pPDA-ODA(98.9:95:5)

100 g of an organic solvent, NMP (N-methyl-2-pyrrolidone) was charged into a reactor equipped with a stirrer in a nitrogen stream, and then 5.863 g (54.215 mmol) of paraphenylene diamine (p-PDA), and 0.571 g (2.853 mmol) of 4,4'-oxydianiline (ODA) were dissolved while maintaining the reactor temperature at 25 °C. To the solution of p-PDA and ODA, 16.606 g (56.440 mmol) of 3,3',4,4'-biphenylcarboxylic dianhydride (s-BPDA) and 56.96 g of NMP were added at the same temperature and dissolved with stirring for a predetermined time to obtain a polyamic acid.
The organic solvent was added in such as amount that the solid concentration of the polyimide precursor solution prepared from the reaction is 12.8 wt% to prepare a polyimide precursor solution.
A polyimide film having a thickness of 10 $\mu$m was prepared in the same manner as in Example 1.

<Experimental Example 1>

A crystallinity, thermal conductivity, specific heat, density, and thermal diffusivity of each of the polyimide films prepared above were measured in the following manner and are shown in Table 1.

<Crystallinity>

The sample was fixed to the sample holder using a magnet and mounted on the sample stage. After z->omega->z alignments, GIXRD (Grazing incidence X-ray Diffraction) experiment was performed with the incident angle fixed (w = 0.4°) and the detector within the range of 5° $\leq$ 2$\theta$ $\leq$ 70°. The step size was 0.04 ° and the time/step was 2 seconds.

<Thermal conductivity>

The thermal conductivity was calculated by the following equation (2).

$$[\text{Equation 2}]$$

$$\text{Thermal conductivity (k)} = C \times \rho \times \alpha$$

wherein, C represents the specific heat (J/g·K), p represents density (g/cm$^3$) and $\alpha$ represents thermal diffusivity (mm$^2$/sec).

<Thermal diffusivity>

The thermal diffusivity of the samples was measured by using LFA 467 Hyperflash at room temperature. A holder for standard sample was a 12.7 mm round holder and graphitized to increase light absorption at the front of the sample and heat release at the back of the sample.

<Specific heat>

Specific heat was analyzed according to ISO 11357-4 and ASTM E 1269 standard using DSC 203 F1 phoenix.

<Density>

The density was measured using a micro balance (MSA 125P, Satorius) and the volume was determined using the respective length measurement method.

For comparison of reproducibility, experiments were repeated 10 times per sample.

[Table 1]

| | Example | | | | Comparative Example | | | | | | | |
|---|---|---|---|---|---|---|---|---|---|---|---|---|
| | 1 | 2 | 3 | 4 | 1 | 2 | 3 | 4 | 5 | 6 | 7 | 8 |
| Film thickness ($\mu$m) | 10 | 10 | 10 | 10 | 10 | 10 | 10 | 10 | 10 | 10 | 10 | 10 |
| Crystallinity | 0.50 | 0.51 | 0.50 | 0.52 | 0.39 | 0.39 | 0.40 | 0.42 | 0.42 | 0.43 | 0.30 | 0.39 |
| Thermal diffusivity $\alpha$ (mm$^2$/s) | 0.072 | 0.083 | 0.086 | 0.091 | 0.059 | 0.060 | 0.062 | 0.064 | 0.067 | 0.068 | 0.050 | 0.063 |
| Specific heat C (J/g·K) | 1.701 | 1.711 | 1.735 | 1.744 | 1.207 | 1.212 | 1.337 | 1.338 | 1.391 | 1.410 | 1.223 | 1.325 |
| Density $\rho$ (g/cm$^3$) | 1.68 | 1.70 | 1.75 | 1.79 | 1.38 | 1.39 | 1.42 | 1.41 | 1.43 | 1.43 | 1.19 | 1.42 |
| Thermal conductivity $\kappa$ (W/m·K) | 0.205 | 0.241 | 0.261 | 0.284 | 0.098 | 0.101 | 0.117 | 0.120 | 0.133 | 0.137 | 0.072 | 0.118 |

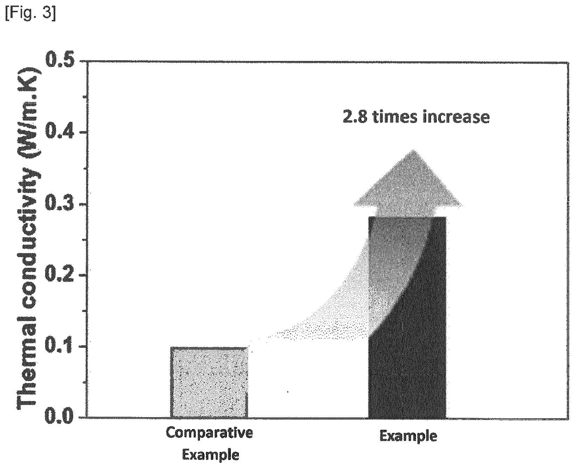

As shown in Table 1 and Fig. 2, the film according to the present invention showed the crystallinity of 0.52, which was increased by 33% or more as compared with the film of the comparative example. Also, the thermal conductivity was increased by 2.8 times as shown in Table 1 and Fig. 3.

It can be seen that the film according to the present invention having a BPDA-pPDA-TFMB/PA skeleton and no siloxane repeating unit and a crystallinity of 0.5 or more has excellent heat radiation properties

While the present invention has been particularly shown and described with reference to specific embodiments thereof, it will be apparent to those skilled in the art that this specific description is merely a preferred embodiment and that the scope of the invention is not limited thereby. It is therefore intended that the scope of the invention be defined by the claims appended hereto and their equivalents.

**Claims**

1.  A polyimide film produced from a polymerization composition comprising 3,3',4,4'-biphenylcarboxylic dianhydride (s-BPDA), 4,4'-paraphenylenediamine (p-PDA), 2,2'-bis(trifluoromethyl)benzidine (TFMB) and phthalic anhydride, the polyimide in the film being end-capped with phthalic anhydride and the polyimide film having a crystallinity of at least 0.5.

2.  The polyimide film according to claim 1, wherein a thermal diffusivity of the film is at least 0.07 $mm^2/s$.

3.  The polyimide film according to claim 1, wherein a thermal conductivity of the film is at least 0.2 W/m·K.

4.  The polyimide film according to claim 1, wherein a molar ratio of 4,4'-paraphenylenediamine (p-PDA) to 2,2'-bis(trifluoromethyl)benzidine (TFMB) is 90:10 to 95:5.

5.  The polyimide film according to claim 1, wherein a molar ratio of the total of 4,4'-paraphenylenediamine (p-PDA) and 2,2'-bis(trifluoromethyl)benzidine (TFMB) to 3,3',4,4'-biphenylcarboxylic dianhydride (s-BPDA) is 100:98.9 to 100:98.75.

6.  The polyimide film according to claim 1, wherein a molar ratio of the phthalic anhydride relative to 1 mole of the total of 4,4'-paraphenylenediamine (p-PDA) and 2,2'-bis(trifluoromethyl)benzidine (TFMB) is 0.02 to 0.025.

7.  A method for producing a polyimide film, comprising the steps of:

    adding a polymerization composition comprising 4,4'-paraphenylenediamine (p-PDA), 2,2'-bis(trifluoromethyl)benzidine (TFMB) and 3,3',4,4'-biphenylcarboxylic dianhydride (s-BPDA) and phthalic anhydride (PA) as an end-capper to a polymerization solvent to prepare a polyimide precursor;
    preparing a polyimide precursor solution comprising the polyimide precursor and an organic solvent;
    applying the polyimide precursor solution on a substrate; and drying and heating the applied polyimide precursor solution.

8.  The method for producing a polyimide film according to claim 7, wherein a molar ratio of 4,4'-paraphenylenediamine (p-PDA) to 2,2'-bis(trifluoromethyl)benzidine (TFMB) is 90:10 to 95:5.

9.  The method for producing a polyimide film according to claim 7, wherein a molar ratio of the total of 4,4'-paraphenylenediamine (p-PDA) and 2,2'-bis(trifluoromethyl)benzidine (TFMB) to 3,3',4,4'-biphenylcarboxylic dianhydride (s-BPDA) is 100:98.9 to 100:98.75.

10.  The method for producing a polyimide film according to claim 7, wherein the phthalic anhydride is reacted in a molar ratio of 0.02 to 0.025 relative to 1 mole of the total of 4,4'-paraphenylenediamine (p-PDA) and 2,2'-bis(trifluoromethyl)benzidine (TFMB).

11.  The method for producing a polyimide film according to claim 7, wherein the final curing temperature in the step for curing process by a drying and heating of the polyimide precursor solution is at least 450 °C.

12.  A flexible display device comprising the polyimide film according to any one of claims 1 to 6 as a substrate.

[Fig. 1]

Good Orientation

In-plane

Amorphous

Thermal conductivity

Good Ordering

Out-of-plane

Amorphous

[Fig. 2]

[Fig. 3]

## INTERNATIONAL SEARCH REPORT

| | International application No. |
|---|---|
| | **PCT/KR2019/000639** |

**A. CLASSIFICATION OF SUBJECT MATTER**

*C08J 5/18(2006.01)i, H01L 51/00(2006.01)i, H01L 51/56(2006.01)i, C08G 73/10(2006.01)i, C08L 79/08(2006.01)i*

According to International Patent Classification (IPC) or to both national classification and IPC

**B. FIELDS SEARCHED**

Minimum documentation searched (classification system followed by classification symbols)
C08J 5/18; B32B 27/00; C08G 73/10; C08J 5/08; C08L 79/08; G06F 3/041; H01L 51/00; H01L 51/56

Documentation searched other than minimum documentation to the extent that such documents are included in the fields searched
Korean utility models and applications for utility models: IPC as above
Japanese utility models and applications for utility models: IPC as above

Electronic data base consulted during the international search (name of data base and, where practicable, search terms used)
eKOMPASS (KIPO internal) & Keywords: polyimide, benzidine, anhydride, diamine

**C. DOCUMENTS CONSIDERED TO BE RELEVANT**

| Category* | Citation of document, with indication, where appropriate, of the relevant passages | Relevant to claim No. |
|---|---|---|
| Y | KR 10-2014-0004655 A (TORAY INDUSTRIES, INC.) 13 January 2014<br>See claim 5; paragraphs [0001], [0038], [0088]-[0091], [0149]-[0152]; and table 1. | 1-12 |
| Y | HUANG, Sen-biao et al. Properties, Morphology and Structure of BPDA/PPD/TFMB Polyimide Fibers. CHEM. RES. CHINESE UNIVERSITIES. 2012, vol. 28, no. 4, pages 752-756<br>See abstract; table 1. | 1-12 |
| A | KR 10-2009-0084772 A (UBE INDUSTRIES, LTD.) 05 August 2009<br>See the entire document. | 1-12 |
| A | KR 10-2017-0069190 A (KOLON INDUSTRIES, INC.) 20 June 2017<br>See the entire document. | 1-12 |
| A | KR 10-2015-0046463 A (KOLON INDUSTRIES, INC.) 30 April 2015<br>See the entire document. | 1-12 |

| ☐ Further documents are listed in the continuation of Box C. | ☒ See patent family annex. |
|---|---|

| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
|---|---|

| Date of the actual completion of the international search | Date of mailing of the international search report |
|---|---|
| 09 MAY 2019 (09.05.2019) | **09 MAY 2019 (09.05.2019)** |

| Name and mailing address of the ISA/KR<br>Korean Intellectual Property Office<br>Government Complex Daejeon Building 4, 189, Cheongsa-ro, Seo-gu, Daejeon, 35208, Republic of Korea<br>Facsimile No. +82-42-481-8578 | Authorized officer<br><br>Telephone No. |
|---|---|

Form PCT/ISA/210 (second sheet) (January 2015)

International application No.

**PCT/KR2019/000639**

| Patent document cited in search report | Publication date | Patent family member | Publication date |
|---|---|---|---|
| KR 10-2014-0004655 A | 13/01/2014 | CN 103261278 A | 21/08/2013 |
| | | CN 103261278 B | 19/11/2014 |
| | | JP 5772601 B2 | 02/09/2015 |
| | | KR 10-1862894 B1 | 30/05/2018 |
| | | SG 191873 A1 | 30/08/2013 |
| | | TW 201237063 A | 16/09/2012 |
| | | TW I542608 B | 21/07/2016 |
| | | US 2013-0289202 A1 | 31/10/2013 |
| | | WO 2012-093586 A1 | 12/07/2012 |
| | | WO 2012-093586 A1 | 09/06/2014 |
| KR 10-2009-0084772 A | 05/08/2009 | CN 101497694 A | 05/08/2009 |
| | | CN 101497694 B | 23/01/2013 |
| | | JP 2009-185101 A | 20/08/2009 |
| | | JP 5233298 B2 | 10/07/2013 |
| | | KR 10-1535508 B1 | 09/07/2015 |
| | | TW 200938568 A | 16/09/2009 |
| | | US 2009-0197068 A1 | 06/08/2009 |
| KR 10-2017-0069190 A | 20/06/2017 | CN 104115238 A | 22/10/2014 |
| | | CN 104115238 B | 22/08/2017 |
| | | EP 2800104 A1 | 05/11/2014 |
| | | JP 2015-508345 A | 19/03/2015 |
| | | JP 5964452 B2 | 03/08/2016 |
| | | KR 10-1688173 B1 | 21/12/2016 |
| | | KR 10-1700094 B1 | 26/01/2017 |
| | | KR 10-1754572 B1 | 06/07/2017 |
| | | KR 10-1754573 B1 | 06/07/2017 |
| | | US 2014-0338959 A1 | 20/11/2014 |
| | | US 9706649 B2 | 11/07/2017 |
| | | WO 2013-100557 A1 | 04/07/2013 |
| KR 10-2015-0046463 A | 30/04/2015 | KR 10-1602686 B1 | 11/03/2016 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020180054983

- KR 1020180164186